# EUROPEAN PATENT APPLICATION

(11) **EP 0 596 864 A2**
(43) Date of publication of application: **11.05.1994**
(21) Application number: 94100767.6
(22) Date of filing: 16.06.1989
(51) Int. Cl.: H03K 19/017, H03K 5/153

(54) **Speed enhancement technique for CMOS circuits**

(30) Priority: 24.06.1988 US 210969
(62) Divisional of application: 89110915.9
(71) Applicant: NATIONAL SEMICONDUCTOR CORPORATION, Santa Clara, California 95052-8090 (US)
(72) Inventor: Proebsting, Robert J., Los Altos, CA 94022 (US)
(74) Representative: Sparing Röhl Henseler Patentanwälte

(57) **Abstract**

A speed enhancement technique for CMOS circuits is disclosed. In the series of logic stages, nodes in the signal path of a pulse are set by preceding logic stages, then reset by feedback from a subsequent logic stage. This eliminates the capacitive burden of resetting any given node from the input signal to allow substantially all of the input signal to be employed in setting the nodes to an active state rather than wasting half the signal in turning off the reset path. The technique is illustrated as applied to RAM circuits.

## Description

This invention relates to circuits employing field effect transistors, and in particular to a technique for substantially increasing the speed of operation of circuits employing complementary field effect transistors.

In MOS circuits the speed of operation is limited by resistance and capacitance, the resistance of an MOS transistor driving the capacitance of the next MOS transistor. Because the output current of an MOS transistor is proportional to its channel width, if a narrow transistor is employed to drive a high capacitance load, a series of cascaded inverters are frequently used. In such circuits the time delay for each stage is proportional to the fan-out (load capacitance) of that stage, which is the ratio of the size (channel width) of the driven device or devices to that of the driving device or devices. Thus, the choice of relative sizes of the driving and driven devices affects the speed of the circuit.

Because the speed of any given inverter stage is a constant times the fan-out of that stage, if a specified fan-out is to be driven using a series of inverters, there are many possible choices. For example, consider a load of 100. If a single inverter with a fan-out of 100 is employed (a 4-micron width stage driving a 400-micron width stage), then the circuit will have a delay of 100 units of time because the delay is a constant times the fan-out. Alternatively, two serial inverter stages could be employed, each with a fan-out of 10, to provide a total fan-out for the circuit of 10 times 10 or 100, yet this driving arrangement has a delay of only 20 units of time (two delays, each of ten units of time). If four inverters are employed, each will have a fan-out of the square root of 10 and the total circuit delay will be four times the square root of 10, or about 12.65 units of time.

Thus, a circuit designer is presented with a range of choices for the number of stages to drive a given size load. There is an optimum number of stages; however, at which the total delay for the circuit is minimized, and that total delay may not be further reduced using conventional techniques. This minimum delay is reached when the size of each stage is the natural logarithm e (approximately 2.7) times the size of the previous stage. In other words, the total channel width of the devices in each subsequent stage is approximately 2.7 times the total channel width of the devices in the preceding stage.

A basic complementary field effect transistor inverter includes a PMOS device connected between a positive supply and an output node and an NMOS device connected between the output node and a negative supply with the gates connected in parallel and to the input.

In such an inverter the input signal going high (to the positive supply voltage) turns off the PMOS device to disconnect the common output node from the high potential, and turns on the NMOS device to pull the output node low by connecting it to the negative supply potential. Because an NMOS device is approximately twice as conductive as a PMOS device for a given gate width and turn- on voltage, by making the NMOS device approximately half the width of the PMOS device, the inverter will have a constant delay for both high-to- low or low-to-high logic transitions.

In all transistors, the channel length usually will be the minimum allowed by the manufacturing technology employed because short channel devices have both low on resistance and low capacitance to minimize switching time. Thus, in a typical inverter chain, a first inverter might include a 10- micron PMOS device and a 5-micron NMOS device. The following inverter (with near optimum fan-out of approximately three) therefore would include a 30-micron PMOS device and 15-micron NMOS device. The third inverter would have a 90-micron PMOS device and a 45-micron NMOS device, etc. In the first inverter the 5-micron NMOS device is driving both a 30-micron PMOS device and 15- micron NMOS device in the second inverter for total of 45 microns, or an NMOS fan-out of 9. Similarly, the 10-micron PMOS device in the first inverter is driving a 30-micron PMOS device and a 15-micron NMOS device in the second inverter for a PMOS fan-out of 4.5. Because the PMOS device is half as conductive as an NMOS device of the same size, the 10-micron PMOS will have a delay equivalent to that of the 5-micron NMOS driving the same load.

In each stage both the NMOS device and the PMOS device are turning on the PMOS device and turning off the NMOS device in the following inverter. Because in each inverter the PMOS device is twice the size of the NMOS device, two-thirds of the charge from the previous NMOS device will go to the PMOS device and one-third to the NMOS device. Similarly, the PMOS device in each inverter will send one-third of its charge to the NMOS device in the following inverter and two-thirds to the PMOS device in the following inverter. Thus, charge from each device in a preceding stage is supplied to each device in a following stage.

One form of CMOS logic in which speed is somewhat enhanced with respect to the inverter chain technique described above is domino logic. See, R. H. Krambeck, et al., "High-Speed Compact Circuits with CMOS," IEEE Journal of Solid-State Circuits (June, 1982) SC-17(3):614-619.

In domino logic circuits, an array of transistors is configured to perform a specified logic function. The output node is precharged to a particular voltage level (typically high for NMOS) while all current paths to the other voltage level (ground for NMOS) are turned off. During this phase the input to each of the gates of all transistors in the circuit are set to the desired level. Next, the current path to the high level is turned off by a clock signal, and the path to ground is turned on. Depending on the states of the input signals, the output node will either float at the high level or be pulled down, thereby evaluating the logic function implemented by the transistor array. The transition from precharge to evaluation is accomplished by a single clock edge applied simultaneously to all gate electrodes in the circuit. Figure 5 of the above paper shows a typical domino logic circuit.

Domino logic, however, suffers from several disadvantages. It operates at undesirably low speed because each logic gate drives an inverter consisting of both a PMOS and an NMOS transistor. It has low throughput because the multiple sequential stages receive a common precharge clock signal, and thus one complete clock cycle is required for each logic operation. Additionally, domino logic cannot provide logic functions in both NMOS and PMOS. Furthermore, in both the inverter chains and domino logic prior art, the logic functions are performed by changes in voltage levels. Because changes in the levels of output nodes are sensed after the circuit reaches a steady state condition, new input information cannot be applied until the circuit is stable. This results in delays until the entire circuit stabilizes, even though only a small portion may be changing.

### SUMMARY OF THE INVENTION

An object of the present invention is a circuit technique which allows circuits employing active components to operate substantially more rapidly than the speed achieved by prior art circuits. The invention is defined in broadest terms by the independent claims.

Preferably the invention is to employ pulses in CMOS circuits to perform only one of the two tasks performed by the voltage levels in prior art circuits. In circuits employing the invention, pulses are used to set a logic node to an active state, then some other pulse generated elsewhere (usually downstream) in the circuit is used to reset the node in preparation for the next active pulse. This technique allows virtually all of the charge from any given stage in a circuit (whether PMOS or NMOS) to be employed in setting a following stage to the active state, with virtually none wasted in resetting. This approach minimizes the time delay inherent in operation of the circuit. Additionally, the use of pulses, rather than levels, allows pipelining of circuit operation. Thus, while one part of the circuit is active, a preceding portion may be reset in anticipation of the next pulse. Embodiments of the invention are illustrated in the accompanying drawings and will be explained hereunder in detail.
Fig. 1 is a schematic of a 1-of-16 decoder;
Fig. 2 is a schematic of a word line decoder and reset circuit;
Fig. 3 is a schematic of a sense amplifier; and
Fig. 4 is a timing diagram for the sense amplifier.

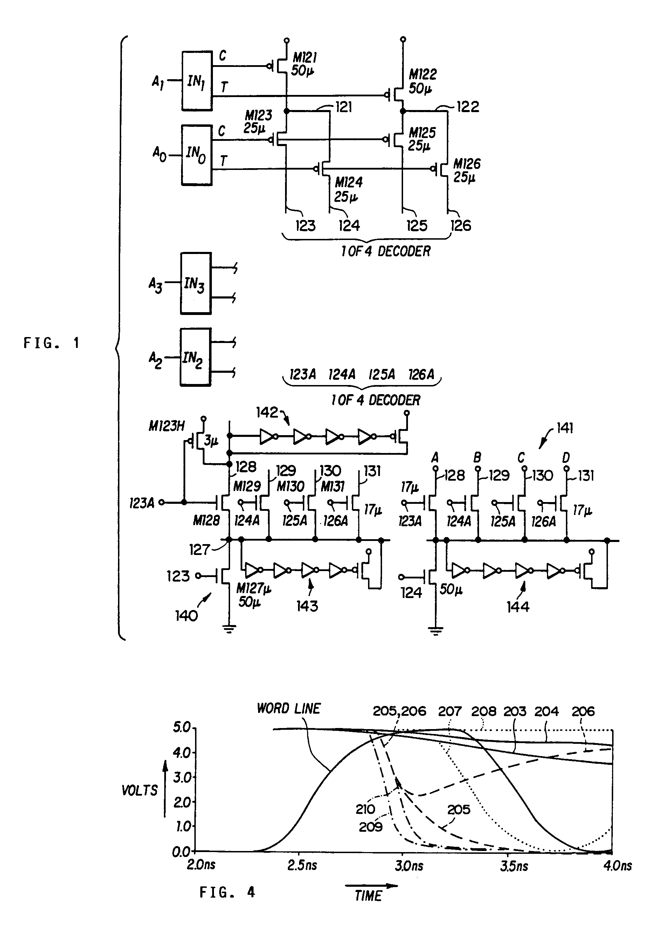

Figure 1 is a circuit schematic of a decoder circuit which employs input buffers.

As shown in Figure 1 a pair of input buffers INo and IN₁ each supply true T and complementary C output signals.

A negative pulse is assumed to occur on one but not both nodes T and C. In a typical memory circuit, input buffer INo responds to a first address Ao, while input buffer IN₁ responds simultaneously to a second address A1. The true output of input buffer IN₁ is coupled to the gate of PMOS transistor M122, while the true output of input buffer INo is coupled to the gates of PMOS transistors M124 and M126. The complementary output of input buffer IN₁ controls the gate of PMOS transistor M121, while the complementary output of input buffer INo controls the gates of PMOS transistors M123 and M125. All of the charge from each input buffer is employed in driving the PMOS devices (none wasted in turning off an NMOS transistor).

This contrasts with prior art devices in which the input buffer drove a complementary pair, resulting in much slower operation.

The source of transistor M121 is connected to the positive supply reference potential, while the drain is coupled to the sources of both transistors M123 and M124. similarly, the source of transistor M122 is coupled to the reference potential while the drain is coupled to the sources of both transistors and M125 and M126. Because transistors M121 and M122 are each 50 microns in width, while transistors M123-M126 are each 25 microns in width, the total loading on input buffer INo will be the same as the loading on input buffer IN₁ .

If input buffer IN₁ pulls output C low, PMOS transistor M121 pulls node 121 high. Because the true output T then remains high, transistor M122 remains off. Also, assume that simultaneously (all buffers have a common activating signal) the complementary output of input buffer INₒ is pulled low, while the true output remains high. Thus, PMOS transistors M123 and M125 conduct, while transistors M124 and M126 remain off. Thus, only output node 123 is pulled high by transistors M121 and M123, while each of nodes 124, 125 and 126 remains low. Nodes 124 and 126 remain low because transistors M124 and M126 are off, while node 125 remains low because, even though transistor M125 is conducting, transistor M122 is not. Thus, for any address input, one of the four nodes 123-126 will be pulled high, while the other three remain at ground. Because of the sizing of the transistors, the selected node is pulled high through a transistor having a width equivalent to 2/3 of 25 microns (a 50-micron transistor in series with a 25-micron transistor).

Each of the nodes 121 through 126 will be the input of a series of four cascaded inverters not shown in the schematic. The final output of each inverter string is connected to the gate of an NMOS transistor which resets its originating node, 121 through 126, to ground. This resetting action is described in detail below for the third stages of decoding.

Each of nodes 123-126, as well as four similar nodes 123A, 124A, 125A, and 126A from decoders connected to input buffers IN₂ and IN₃, is connected to a second stage decoder 140, half of which is shown at the bottom of Figure . For example, node 123 is connected to drive the gate of NMOS transistor M127 which is connected between a node 127 and ground. Four more NMOS transistors M128-M131 are connected between node 127 and corresponding nodes 128-131 to generate four outputs in this 1-of-16 decoder. Assume addresses Ao and A₁ pulled node 123 high, turning on transistor M127. Depending upon the address supplied to input buffers IN₂ and IN₃, one of the nodes 123A through 126A will be driven high. Therefore, one of transistors M128-M131 will be turned on, thereby pulling one of nodes 128-131 to ground. All of the remaining nodes 128-131 will remain high.

Additional second stages 141 of decoders are connected to nodes 124, 125 and 126 from the first stage, and are connected in a similar manner to the second stage with nodes 123A through 126A, with the result that the four address signals Ao-A3 to the input buffers will select 1 of 16 nodes to pull to ground. (The inverter chains 142, 143 and 144 in Figure 1 are discussed below.)

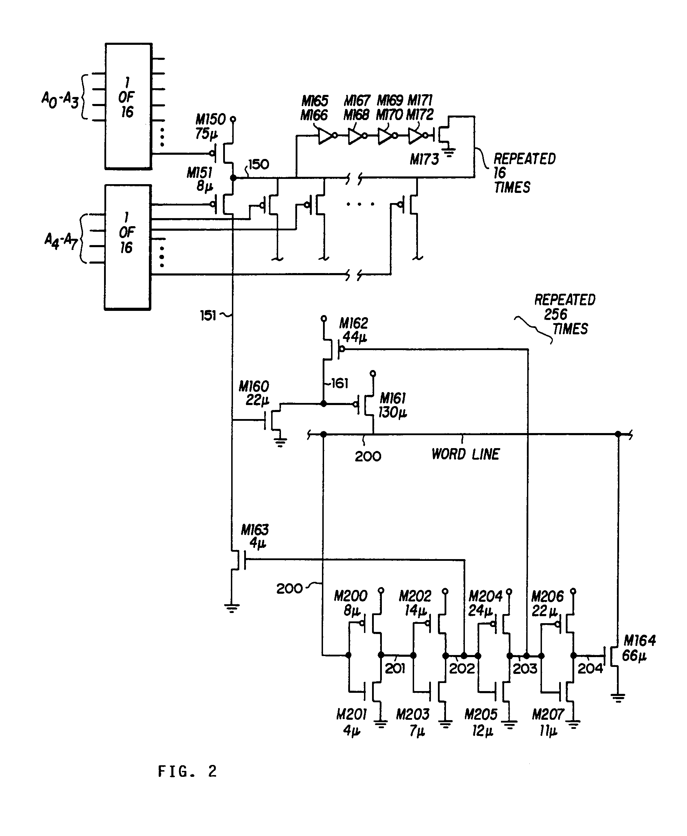

Figure 2 illustrates how one 1-of-16 decoder may be combined with another 1-of-16 decoder to provide a 1-of-256 decoder, for example, to pull an addressed memory array word line high to read one or more memory cells connected to that word line. In Figure the output (node 128 for example) being pulled low is pulled low through an equivalent of a 12.5 micron transistor. Because an NMOS device can drive a PMOS device six times its width, transistor M150 is 75 microns wide. For the address decoder coupled to address bits A4-A₇, however, each output line drives 16 transistors, and accordingly, transistor M151 is 8 microns wide. The loading of 16 PMOS transistors each 8 microns wide would appear to be that of a 128- micron transistor. When only one transistor at a time has its source at the positive supply and therefore has a channel formed, only that one has its full channel capacitance. The other 15 transistors with their sources negative have no channel formed and have reduced capacitance. The 16 transistors together represent approximately equivalent loading of a single transistor about 75 microns wide having a channel formed. Thus, both 1-of-16 decoders have similar capacitive loading. Node 151, if selected, will be pulled up through an equivalent of about a 7 micron transistor. Because any PMOS transistor drives an NMOS transistor approximately three times its width, the NMOS transistor M160 is about 22 microns wide.

For this example, the capacitive loading of a word line is assumed to be about that of the gate of a 400-micron wide transistor. Thus, 22-micron NMOS transistor M160 is used to drive a 130- micron wide PMOS transistor M161, which in turn pulls the word line high. Therefore, if all of the nodes were at the proper (inactive) level to begin, and the appropriate address is selected, node 123 (see Figure ) is pulled high (active), node 128 is pulled low (active) one delay later, to pull node 151 (Figure ) high (active) yet one delay later to turn on transistor M160 pulling node 161 low (active) yet one delay later and finally, in turn, pulling the word line high (active) through transistor M161 still one delay later.

Once the word line goes high, it must remain high long enough to read or write the memory cell but it must then be reset in anticipation for a new memory cycle. The word line as well as nodes 151 and 161 are reset by employing four inverters comprising transistors M200-M207. When the word line goes high, it causes node 201 to go low one delay later, node 202 to go high two delays later, node 203 to go low three delays later, and node 204 to go high four delays later. When node 202 goes high it turns on transistor M163, thereby resetting node 151 low. Note that a similar feedback path will reset (turn off) the gates of transistors M150 and M151 one delay before node 151 is reset. As node 151 is reset low, node 203 also goes low both resulting from node 202 going high. Node 203 going low resets node 161 high one delay after node 151 was reset low. Coincident with node 161 resetting high (from 203 going low), node 204 goes high turning on M164 to reset the word line low. Thus, every node has an active pulse five delays wide followed by a reset pulse five delays wide. In all cases the reset pulse starts at about the same time the transistor that caused the active pulse is turned off. The resetting function imposes a negligible load on the nodes being reset. For example, pulling the word line high without any resetting capability involves pulling the equivalent of a 400-micron transistor high. The provision of the reset capability by the inverter chain M200-M207 involves an additional load of only 12 microns on the word line. Importantly, in contrast to the prior art dynamic circuits (using precharge techniques), only nodes which have changed state are reset. Thus, the 255 word lines which were not pulled up, and which therefore do not require resetting, are not reset, while only the single word line which changed state is reset.

In a similar circuit transistors M165-M172 of Figure 2 form a four-inverter delay chain which accepts as an input the positive transition of node 150, and in response, four delays later, turns on transistor M173 to pull node 150 back to the inactive state (ground) in anticipation of a new memory cycle. The reset capability burdens node 150 with only a small additional load. (The transistors in each inverter are twice the size as in the preceding inverter).

The same resetting technique described above is also applied to the decoder circuit shown in Figure . For example, a chain of four inverters 143 and an additional PMOS transistor is used to reset node 127 inactive (high). A similar sequence of inverters 142 resets node 128 inactive (high), while inverters 144 reset the node to which they are connected. Virtually all nodes throughout the circuit have the same algorithm for resetting: when a node is driven active (positive or negative), it causes its own reset (negative or positive) some fixed number of delays later. The active pulse of one node may be the reset pulse of an earlier node.

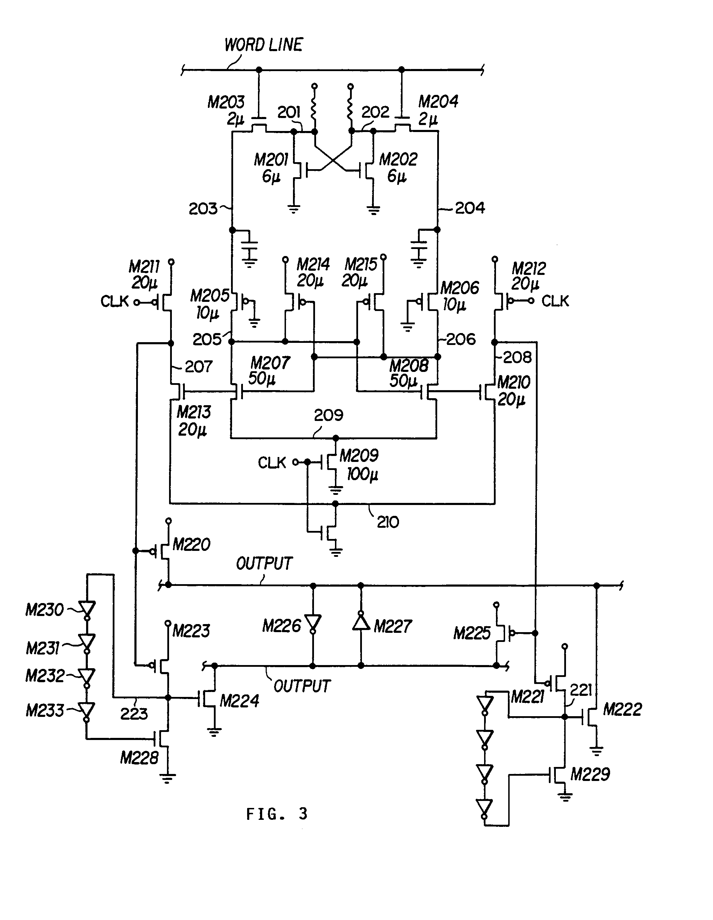

Figure 3 is a schematic diagram of a memory cell and sense amplifier for use in conjunction with the circuits of Figures 1 and 2. The sense amplifier senses a differential signal from a pair of bit lines 203 and 204. This differential signal is induced by addressing a memory cell coupled between the bit lines. The memory cell may be static or a dynamic memory cell. A well-known static memory cell comprises cross-coupled transistors M201 and M202 connected to the word line through transistors M203 and M204. When the word line is turned on (positive pulse from the decoder described above in conjunction with Figures 1 and 2), transistors M203 and M204 conduct. A bit of data stored in the cell causes either node 201 or 202 to be at 0 volts, while the other is held high by a load resistor coupled to the reference positive supply potential.

Reading of the cell is as follows. Assume that node 201 was at 0 volts. (Transistor M202 is off and M201 is on.) When transistors M203 and M204 are turned on, node 203 will begin discharging toward 0 volts, while node 204 does not discharge because node 202 is at the same high potential as node 204. Because the PMOS devices M205 and M206 are turned on (gate tied to ground), they conduct the voltage on node 203 to node 205 and the voltage on node 204 to node 206.

Transistors M205 and M206 isolate the high capacitance bit lines (nodes 203 and 204) from the sense amplifier. NMOS transistors M207 and M208 are cross-coupled as are PMOS transistors M214 and M215.

The input clock signal CLK goes high (a later signal than that used for the address input buffers and about two delays after the selected word line goes active (high)), node 209 is pulled to ground. Because node 205 is at a lower voltage than node 206, as node 209 is pulled down transistor M207 will conduct slightly more than transistor M208, thereby pulling node 205 down faster than node 206. As node 205 falls further, PMOS transistor M215 is turned on, pulling node 206 back to the positive supply voltage. As a result node 205 is pulled to ground as node 206 is pulled positive, as more clearly shown in Figure 4.

In the same manner node 209 will fall faster than node 210, as is also shown in Figure 4. Node 210 never gets substantially more than one threshold voltage below node 205 so transistor M210 remains essentially off. As a result node 208 remains high this cycle. But node 206, returning to the positive supply voltage, exceeds the threshold of M213 as node 210 goes to ground so node 207 is driven to ground (active).

The pulse from node 207 is employed by the output shown in the bottom portion of Figure 3. The negative-going pulse on node 207 turns on transistor M220 to pull the output to the high reference potential, overpowering small inverter M227. PMOS transistor M223 is also turned on, driving node 223 positive and turning on NMOS transistor M224 to pull the complementary output low, overpowering small inverter M226.

If, instead, a pulse had been supplied by node 208, PMOS transistor M221 would have been turned on to pull node 221 high, turning on NMOS transistor M222 to pull the output line low. In this case, transistor M225 pulls the complementary output high. Thus, the output line is pulled high as a result of the negative (active) pulse on node 207 and low as a result of the negative (active) pulse on node 208, thereby reflecting the contents of the memory cell coupled to the bit lines 203 and 204. In the absence of pulses, caused by new transitions of the clock input, inverters M226 and M227 indefinitely hold the last read data on the output line and complementary output line. Relatively small transistors are employed in these inverters so that they may be easily overcome by contrary signals on the output lines.

The negative pulse on either node 207 or node 208 is conveniently reset to V_{cc} (inactive) by PMOS transistors M211 or M212. Inverters M230-M233 are coupled from node 223 back to node 223 to reset it low (inactive) after each pulse. In the manner described above a positive pulse on node 223, four inverter delays later, turns on a positive pulse on transistor M228 to pull node 223 back to its original inactive state. Similarly, a negative pulse on node 208 causes a positive pulse on node 221 which is terminated four delays later by a positive pulse on the gate of M229. One delay before node 223 on node 224 is reset low, node 207 or node 208 is reset high by transistor M211 or M212, respectively.

Accordingly, each time a pulse is received by the input buffers, it ripples through the input buffers, the decoders, turns on the selected word line, activates the sense amplifier, and updates the information stored on the true and complement output lines. And at most logic stages along the way, an active pulse causes its own reset pulse four (any even number) delays later. And after the reset pulse terminates (four delays after it starts), the logic node is ready to receive a new active pulse. Thus, after an active pulse followed by a reset pulse, any node is ready to accept a new active pulse. Thus, if there are 20 total logic delays from input to output, a second memory cycle can begin when the first cycle is about half way from input to output. Thus, the circuit can have a cycle time twice as fast as its access time.

Figure 4 is a timing diagram illustrating the timing of the signals for the example above describing the operation in Figure 3. The word line goes high beginning at approximately 2.3 nanoseconds. Node 209 discharges slightly more rapidly than node 210, being about a volt lower at any given instant. The lower potential of node 203 with respect to node 204 causes transistor M207 to pull node 205 to ground, while node 206, after initially falling, is pulled back high by PMOS transistor M215 and the low potential of node 205. The resulting low pulse on line 207 is shown, while line 208 remains almost continuously at 5 volts.

Although a preferred embodiment of the invention has been described above with reference to the operation of a specific series of RAM circuits, it should be appreciated that the invention is not so limited and may be employed in many different types of CMOS circuits. The scope of the invention is set forth in the appended claims.

## Claims

1. A circuit comprising:
a node;
logic means coupled to the node for placing the node in one of two logic states at a first time;
resetting means coupled to the node and responsive to the logic states of the node for changing the logic state of the node at a second time after the first time in response to the logic state of the node at the first time.

2. A circuit as in claim 1 wherein the resetting means comprises:
a plurality of serially-connected inverters, a first one of which is connected to receive signals supplied to the node; and
a resetting circuit connected between the node and a source of signals representative of a desired reset level for the node, the resetting circuit being controlled by a later one of the inverters.

3. A circuit as in claim 2 wherein the resetting circuit comprises a field effect transistor having a gate connected to the later inverter, a source connected to the source of signals, and a drain connected to the node.

4. A circuit as in claim 2 wherein the plurality is an even integer.

5. A circuit as in claim 4 wherein the plurality is four.

6. A circuit comprising:
a selected logic stage capable of being placed in one of a first and a second logic states;
at least one preceding logic stage coupled to the selected logic stage for controlling the first logic state; and
at least one following logic stage coupled to the selected logic stage for controlling the second logic state.

7. A method of improving operating speed of field effect transistor circuits comprising:
providing a pulse at an input node;
supplying the pulse signal to a first transistor coupled to the input node to thereby cause the first transistor to change the state of an output node coupled to the first transistor;
using the change in state of the output node to cause a reset circuit to generate a reset signal; and
supplying the reset signal to a second transistor coupled to the output node to cause the output node to change state before arrival of another pulse.

8. A method as in claim 7 wherein the step of using the change comprises:
propagating the pulse through delay means to the reset circuit.
